# EUROPEAN PATENT APPLICATION

(11) **EP 4 757 174 A1**
(43) Date of publication of application: **10.06.2026**
(21) Application number: 25211581.1
(22) Date of filing: 28.10.2025
(51) Int. Cl.: H03F 1/26, H03F 3/08

(54) **TRANSIMPEDANCE AMPLIFIER CIRCUIT AND MEASURING INSTRUMENT**

(30) Priority: 05.12.2024 JP 2024212549
(71) Applicant: Fuji Electric Co., Ltd., Kawasaki-shi, Kanagawa 210-9530 (JP)
(72) Inventor: MORITA, Akira, Kanagawa, 210-9530 (JP)
(74) Representative: Appelt, Christian W.

(57) **Abstract**

To provide a transimpedance amplifier circuit capable of amplifying current with low noise and high magnification, and a measuring instrument with the transimpedance amplifier circuit.

A transimpedance amplifier circuit includes a first transimpedance amplifier that converts current to voltage; and one or more circuit blocks connected to an output side of the first transimpedance amplifier. Each of the circuit blocks includes a conversion circuit that converts the voltage to current, and a second transimpedance amplifier connected to an output side of the conversion circuit that converts the current to voltage. A measuring instrument includes the transimpedance amplifier circuit.

## Description

### TECHNICAL FIELD

The present disclosure relates to a transimpedance amplifier circuit and a measuring instrument.

### BACKGROUND

Conventionally, by providing a feedback circuit, a technology to realize a transimpedance amplifier having a broadband and high gain has been known (see, for example, Patent Document 1).

### RELATED-ART DOCUMENT

### PATENT DOCUMENT

Patent Document 1: Patent No. 7344506

In order to achieve high sensitivity in measurements in measuring instruments such as optical instruments or radiation instruments, it is required to amplify minute current with low noise and high magnification. A regulated cascode (RGC) circuit, which is one of transimpedance amplifiers, can amplify current with low noise and high magnification, compared with other systems.

In a conventional technology, a voltage amplifier circuit is connected to an output side of a single-stage RGC circuit because amplification by the single-stage RGC circuit has limits for high magnification. However, in a voltage amplification system, it is difficult to reduce noise due to thermal noise or the like of transistors or resistors. In this case, in a conventional transimpedance amplifier circuit in which the voltage amplifier circuit is connected to the output side of the single-stage RGC circuit, it is difficult to reduce noise in the entire circuit.

The present disclosure provides a transimpedance amplifier circuit capable of amplifying current with low noise and high magnification, and a measuring instrument with the transimpedance amplifier circuit.

### SUMMARY

In one aspect of the present disclosure, a transimpedance amplifier circuit is provided, including:
a first transimpedance amplifier that converts or is adapted to convert current to voltage; and
one or more circuit blocks connected to an output side of the first transimpedance amplifier.
Each of the circuit blocks includes:
a conversion circuit that converts or is adapted to convert the voltage to current, and
a second transimpedance amplifier connected to an output side of the conversion circuit that converts or is adapted to convert the current to voltage.

In another aspect of the present disclosure, a measuring instrument including a transimpedance amplifier circuit is provided.

### Effect of the Invention

In the present disclosure, a transimpedance amplifier circuit capable of amplifying current with low noise and high magnification, and a measuring instrument with the transimpedance amplifier circuit can be provided.

### BRIEF DESCRIPTION OF THE DRAWINGS

FIG. 1 is a diagram showing a configuration example of a measuring instrument including a transimpedance amplifier circuit according to a first embodiment.
FIG. 2 is a circuit diagram showing a specific example of the measuring instrument including the transimpedance amplifier circuit according to the first embodiment.
FIG. 3 is a diagram showing a configuration example of the measuring instrument including the transimpedance amplifier circuit according to a second embodiment.
FIG. 4 is a circuit diagram showing a specific example of the measuring instrument including the transimpedance amplifier circuit according to the second embodiment.
FIG. 5 is a circuit diagram showing a specific example of a common-emitter transimpedance amplifier.
FIG. 6 is a circuit diagram showing a specific example of a common-base transimpedance amplifier.
FIG. 7 is a circuit diagram showing a specific example of a V/I conversion circuit using a PNP transistor.
FIG. 8 is a circuit diagram showing a specific example of a V/I conversion circuit using an NPN transistor.
FIG. 9 is a circuit diagram showing a specific example of a current mirror V/I conversion circuit.
FIG. 10 is a circuit diagram showing a specific example of a multi-current mirror V/I conversion circuit.

### DETAILED EMBODIMENTS

Embodiments of the present disclosure will be described below with reference to the drawings.

The present disclosure provides an approach for achieving high sensitivity of a transimpedance amplifier circuit, which is one of photocurrent-electrical conversion amplifiers used in measuring instruments such as optical measuring instruments or radiation measuring instruments. This approach is particularly suitable for use in front-end amplification of portable radiation measuring instruments that require operation at low current consumption.

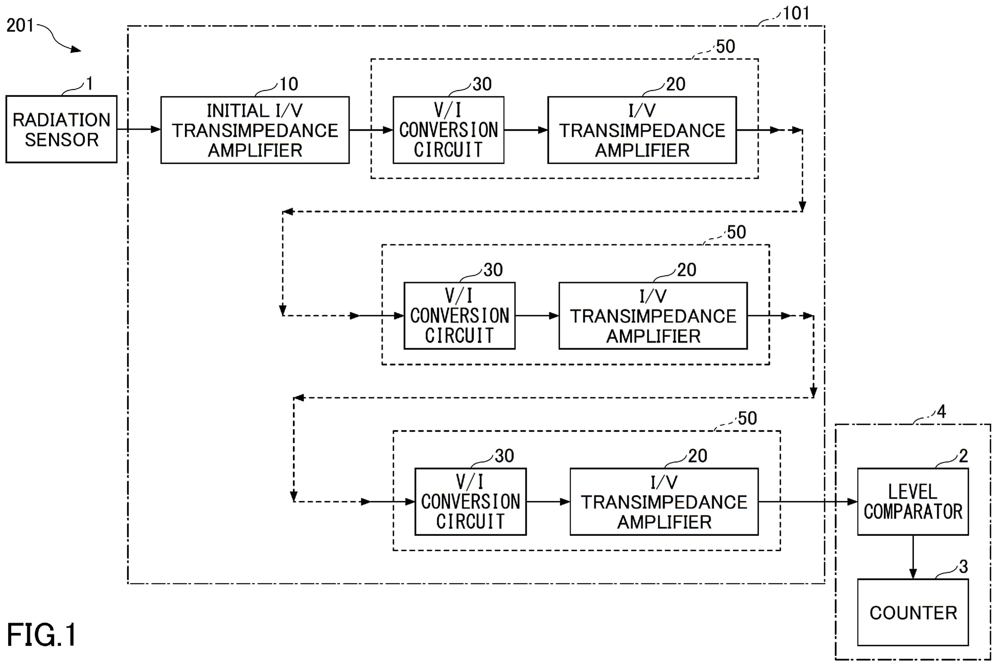

FIG. 1 shows an example configuration of a measuring instrument including a transimpedance amplifier circuit according to a first embodiment. A measuring instrument 201 includes a radiation sensor 1, a transimpedance amplifier circuit 101, and a detection circuit 4.

The radiation sensor 1 is an example of a sensor that outputs current or charge to a first-stage I/V transimpedance amplifier 10 within the transimpedance amplifier circuit 101 through AC coupling (AC coupling). The radiation sensor 1 may be reverse-biased for higher sensitivity and broader bandwidth. In order to remove the reverse bias voltage, an output of the radiation sensor 1 is supplied to the first-stage I/V transimpedance amplifier 10 in the transimpedance amplifier circuit 101 trough AC coupling.

The transimpedance amplifier circuit 101 is a converter that converts current to voltage. In this example, the transimpedance amplifier circuit 101 converts a current pulse corresponding to an amount of electric charge output from the radiation sensor 1, to a voltage pulse, and outputs the voltage pulse to a level comparator 2 in the detection circuit 4. The transimpedance amplifier circuit 101 generates the voltage pulse that has a peak value proportional to an amount of charge output from the radiation sensor 1.

The detection circuit 4 detects the energy of radiation (for example, alpha radiation) based on the voltage pulse from the transimpedance amplifier circuit 101. For example, the detection circuit 4 generates an energy spectrum as a histogram of the number of voltage pulses falling within a reference energy bandwidth during a reference time period. The detection circuit 4 can determine the radioactive nuclides contained in a measurement sample and their respective concentrations from the generated energy spectrum. The detection circuit 4 externally outputs a detection result based on the voltage pulse from the transimpedance amplifier circuit 101.

The detection circuit 4 includes, for example, the level comparator 2 and a counter 3.

The level comparator 2 is an example of a comparator to which the output of the I/V transimpedance amplifier 20 included in a last circuit block of one or more circuit blocks 50 in the transimpedance amplifier circuit 101 is supplied. The level comparator 2 compares the voltage pulse from the I/V transimpedance amplifier 20 included in the last circuit block 50 with a predetermined threshold voltage, and outputs a pulse voltage signal indicating a magnitude comparison result between the voltage pulse and the predetermined threshold voltage.

The counter 3 counts the pulse voltage signal from the level comparator 2. Based on the number of pulse voltage signals counted by the counter 3, the detection circuit 4 can determine the radioactive nuclides contained in the measured sample and their concentration.

The transimpedance amplifier circuit 101 includes the I/V transimpedance amplifier 10 that converts current to voltage, and includes one or more circuit blocks 50 connected in cascade after the I/V transimpedance amplifier 10. FIG. 1 illustrates a configuration in which three circuit blocks 50 are connected in cascade after the I/V transimpedance amplifier 10. The number of circuit blocks 50 is not limited to three, and it is sufficient that at least one circuit block is used.

The I/V transimpedance amplifier 10 is an example of a first transimpedance amplifier that converts current to voltage. Each of M circuit blocks 50 includes a V/I conversion circuit 30 that converts voltage to current, and an I/V transimpedance amplifier 20 connected in cascade after the V/I conversion circuit 30. M is an integer of 1 or more. The I/V transimpedance amplifier 20 is an example of a second transimpedance amplifier that converts current to voltage.

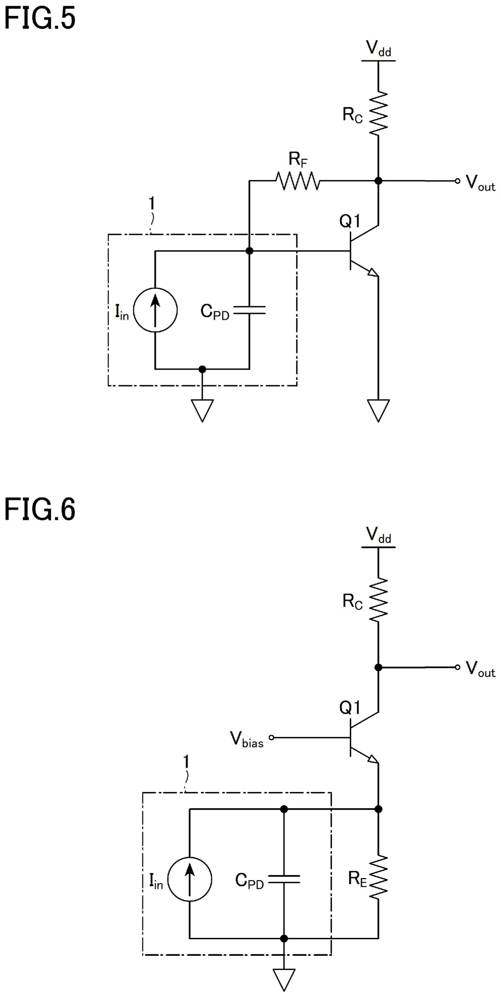

As described above, examples of the I/V transimpedance amplifier include the RGC circuit, the common-emitter transimpedance amplifier (FIG. 5), the common-base transimpedance amplifier (FIG. 6), and the like. The I/V transimpedance amplifier 10 and the I/V transimpedance amplifier 20 can amplify current with low power consumption, low noise, and high magnification, by adopting these circuits described above.

In FIGS. 5 and 6, Iᵢₙ represents the current output from the radiation sensor 1. C_{PD} represents input capacitance such as parasitic capacitance of the radiation sensor 1. The common-emitter transimpedance amplifier of FIG. 5 has a transistor Q1, a resistor R_{C}, and a resistor R_{F}. The common-base transimpedance amplifier of FIG. 6 has a transistor Q1, a resistor R_{C}, and a resistor R_{E}.

In the present disclosure, in order to increase an amplification factor of the transimpedance amplifier circuit 101, the transimpedance amplifier circuit 101 includes N I/V transimpedance amplifiers. N is an integer of 2 or more. The N I/V transimpedance amplifiers include a first-stage I/V transimpedance amplifier 10 and M I/V transimpedance amplifiers 20, where N = M + 1.

Since the output of the I/V transimpedance amplifier is a voltage output, the I/V transimpedance amplifier cannot be directly connected to the output side of the I/V transimpedance amplifier. In this case, a V/I conversion circuit 30 is provided between an upstream I/V transimpedance amplifier and a downstream I/V transimpedance amplifier. Gain of the V/I conversion circuit 30 is preferably relatively low so as not to generate noise.

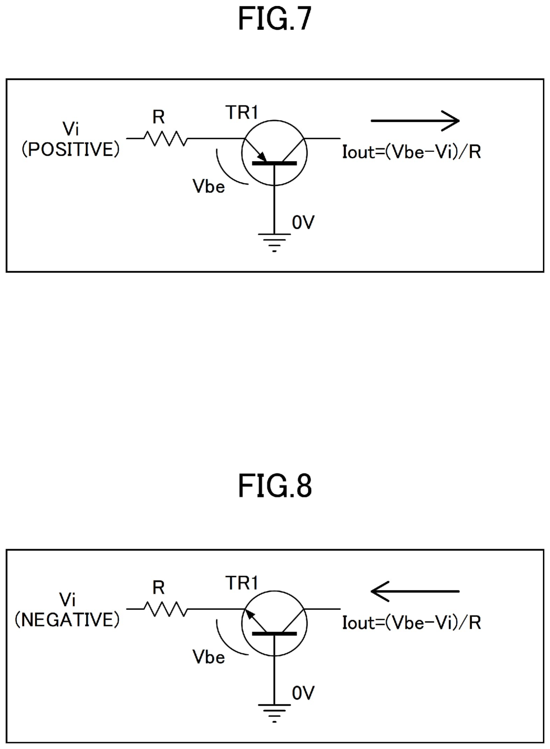

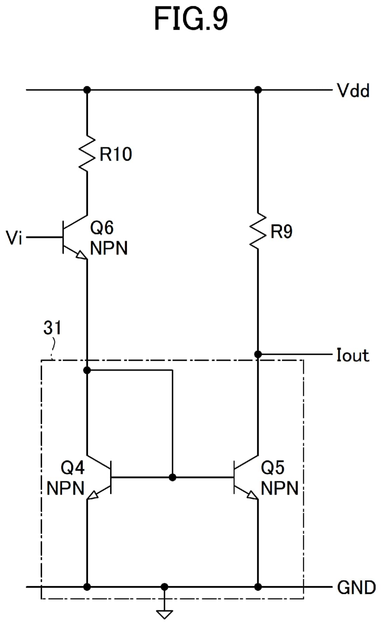

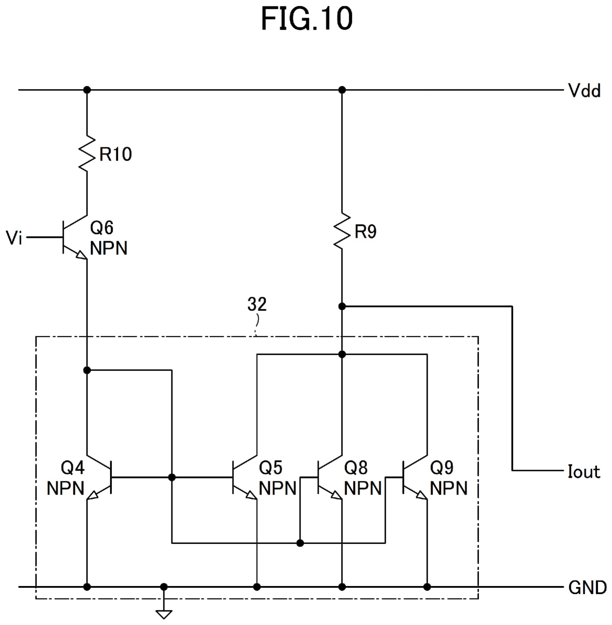

Examples of the V/I conversion circuit include an emitter follower (or a source follower) with a gain of 1, a V/I conversion circuit (FIG. 7) that converts voltage to current by a PNP transistor, a V/I conversion circuit (FIG. 8) that converts voltage to current by using an NPN transistor, a V/I conversion circuit (FIG. 9) that converts voltage to current by a current mirror circuit, and a V/I conversion circuit (FIG. 10) that converts voltage to current by a multi-current mirror circuit. The V/I conversion circuit may be a circuit that converts the voltage to the current by a junction field-effect transistor (J-TFT) or an operational amplifier. By adopting these circuits in the V/I conversion circuit 30, the gain of the V/I conversion circuit 30 can be reduced and thus noise can be reduced.

The V/I conversion circuit shown in FIG. 7 converts a positive voltage Vi to a current Iout by a PNP transistor TR1. The V/I circuit of FIG. 7 has a PNP transistor TR1 and a resistor R. The PNP transistor TR1 has a grounded base, an emitter to which a voltage Vi is applied via a resistor R, and a collector that outputs a current Iout.

The V/I conversion circuit of FIG. 8 converts a negative voltage Vi to a current Iout by an NPN transistor TR1. The V/I circuit of FIG. 8 has the NPN transistor TR1 and a resistor R. The NPN transistor TR1 has a grounded base, an emitter connected to the voltage Vi via the resistor R, and a collector that outputs the current Iout.

The V/I conversion circuit of FIG. 9 converts a voltage Vi to a current Iout by a current mirror circuit 31. The V/I conversion circuit of FIG. 9 has the current mirror circuit 31, resistors R9 and R10, and a transistor Q6. The current mirror circuit 31 is a current mirror circuit that includes transistors Q4 and Q5.

The V/I conversion circuit of FIG. 10 converts a voltage Vi to a current Iout by a current mirror circuit 32. The V/I conversion circuit of FIG. 10 has a current mirror circuit 32, resistors R9 and R10, and a transistor Q6. The current mirror circuit 32 is a multi-current mirror circuit that includes transistors Q4, Q5, Q8, and Q9.

In this arrangement, the transimpedance amplifier circuit 101 shown in FIG. 1 includes the transimpedance amplifier 10 that converts the current to the voltage, and one or more circuit blocks 50 connected to the output side of the transimpedance amplifier 10. Each of the one or more circuit blocks 50 includes a V/I conversion circuit 30 that converts the voltage to the current, and includes an I/V transimpedance amplifier 20 connected to an output side of the V/I conversion circuit 30 that converts the current to the voltage. The amplification factor of the transimpedance amplifier circuit 101 is increased by N I/V transimpedance amplifiers, which include a first-stage I/V transimpedance amplifier 10 and M I/V transimpedance amplifiers 20. Each V/I conversion circuit 30 with low gain is connected between an upstream I/V transimpedance amplifier and a downstream I/V transimpedance amplifier, and thus increases in noise are suppressed. As a result, in the configuration shown in FIG. 1, the transimpedance amplifier circuit 101 that is capable of amplifying the current with low noise and high magnification, and the measuring instrument 201 with the transimpedance amplifier circuit 101 can be provided.

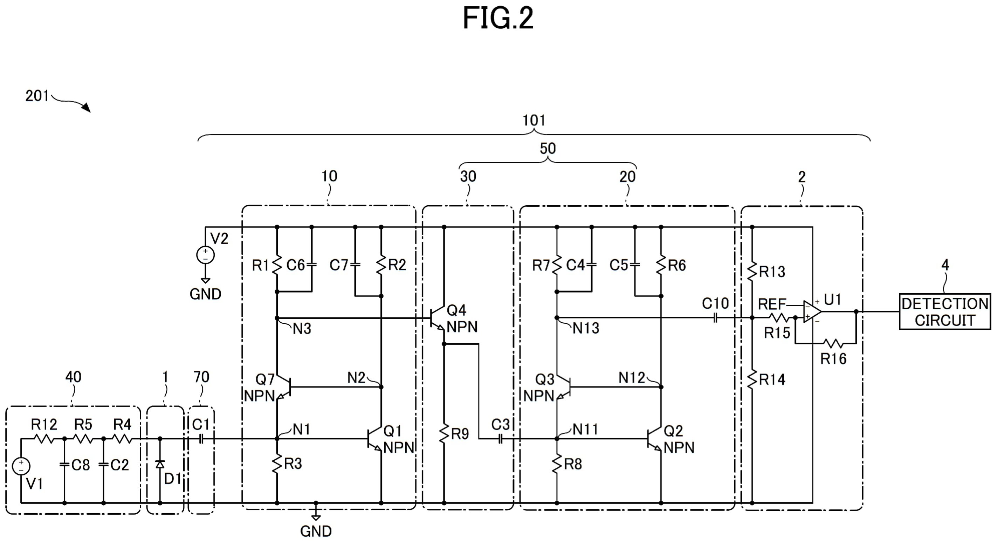

FIG. 2 is a circuit diagram showing a specific example of the measuring instrument including the transimpedance amplifier circuit according to the first embodiment. FIG. 2 shows a case where one circuit block 50 is used. The measuring instrument 201 includes the radiation sensor 1, a reverse bias circuit 40, a DC blocking circuit 70, the transimpedance amplifier circuit 101, and the detection circuit 4.

The radiation sensor 1 has a radiation detection element D1. The radiation detection element D1 may have a p-n junction or a hetero-junction formed on one side of a high-resistivity single-crystal silicon wafer, and a reverse bias is applied to the junction to form depletion layers on both sides of the junction. The radiation detection element D1 outputs charge according to the energy of radiation (for example, gamma rays) that is incident on the depletion layer.

The reverse bias circuit 40 applies a reverse bias V1 to the radiation detection element D1. The reverse bias circuit 40 has resistors R12, R5, and R4 and capacitors C8 and C2.

The DC blocking circuit 70 blocks a DC component to be input to the I/V transimpedance amplifier 10. In this example, the DC blocking circuit 70 has a capacitor C1 connected between the radiation sensor 1 and the I/V transimpedance amplifier 10, and blocks the DC component to be input to the I/V transimpedance amplifier 10 by using the capacitor C1. The capacitor C1 provides AC coupling between the radiation sensor 1 and the I/V transimpedance amplifier 10.

The I/V transimpedance amplifier 10 is an RGC transimpedance amplifier. The I/V transimpedance amplifier 10 has transistors Q1 and Q7, resistors R1, R2, and R3, and capacitors C6 and C7. The transistor Q1 has a base connected to a node N1, an emitter connected to a ground GND, and a collector connected to a node N2. The node N1 is a connection point between an emitter of the transistor Q7 and one end of the resistor R3, and a cathode of the radiation detection element D1 is connected to the node N1 via the capacitor C1. The resistor R3 is connected between the node N1 and the ground GND. The transistor Q7 has a base connected to the node N2, an emitter connected to the node N1, and a collector connected to a node N3. The resistor R1 is connected between a power supply V2, which supplies a voltage, and a node N3. A capacitor C6 is connected in parallel to the resistor R1. The resistor R2 is connected between the power supply V2 and the node N2. The capacitor C7 is connected in parallel with the resistor R2.

The V/I conversion circuit 30 is an emitter follower that converts a voltage output from the node N3 of the I/V transimpedance amplifier 10 to a current, and that outputs the current. The V/I conversion circuit 30 has a transistor Q4, a resistor R9, and a capacitor C3. The transistor Q4 has a base connected to the node N3, a collector connected to the power supply V2, and an emitter connected to the ground GND via the resistor R9. The capacitor C3 blocks a DC component to be input to the I/V transimpedance amplifier 20.

The I/V transimpedance amplifier 20 is an RGC transimpedance amplifier, and has the same circuit configuration as the I/V transimpedance amplifier 10. The I/V transimpedance amplifier 20 has transistors Q2 and Q3, resistors R7, R6, and R8, and capacitors C4 and C5. Nodes N11, N12, and N13 correspond to the nodes N1, N2, and N3. A capacitor C10 blocks a DC component to be input to the level comparator 2.

The level comparator 2 has a voltage divider circuit that performs voltage division of the I/V transimpedance amplifier 20 using the resistors R13 and R14; a comparator U1 that compares an output voltage of the voltage divider circuit with a reference voltage REF; and resistors R15 and R16 connected to the comparator U1.

The RGC I/V transimpedance amplifiers 10 and 20 have low power consumption, high speed, and low noise, and the V/I conversion circuit 30 is an emitter follower with a gain of 1. In this arrangement, the transimpedance amplifier circuit 101 can reduce power consumption and noise even when the gain is increased.

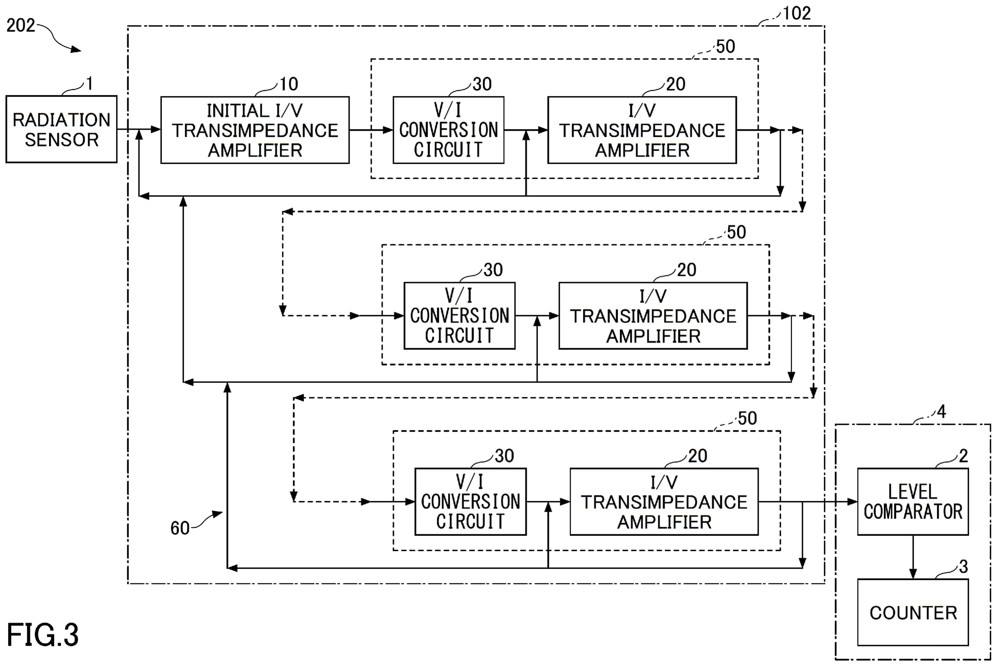

FIG. 3 is a diagram showing a configuration example of the measuring instrument including the transimpedance amplifier circuit according to a second embodiment. In the second embodiment, description of the same configuration, operation, and effect as in the first embodiment will be omitted by referring to the above description.

The transimpedance amplifier circuit 102 shown in FIG. 3 includes a feedback circuit 60 that feeds back one or more outputs of M circuit blocks 50. The feedback circuit 60 feeds back the one or more outputs of the M circuit blocks 50 to thereby achieve higher frequency and stabilization of the transimpedance amplifier circuit 102.

The feedback circuit 60 feeds back one or more outputs of the M I/V transimpedance amplifiers 20. For example, the feedback circuit 60 feeds back one or more outputs of the M I/V transimpedance amplifiers 20 to an input side of the I/V transimpedance amplifiers 10. In this arrangement, high-frequency operation and stabilization of the transimpedance amplifier 102 are achieved. The input side of the I/V transimpedance amplifier 10 is not limited to an input of the I/V transimpedance amplifier 10, and a circuit preceding the input of the I/V transimpedance amplifier 10 may be used. The circuit preceding the input of the I/V transimpedance amplifier 10 is, for example, a circuit between the radiation sensor 1 and the input of the I/V transimpedance amplifier 10.

The feedback circuit 60 may feed back an output of a target I/V transimpedance amplifier 20 to a portion or all of: the input to the target I/V transimpedance amplifier 20; and inputs to one or more I/V transimpedance amplifiers 20 preceding the target I/V transimpedance amplifier 20. In this arrangement, high-frequency operation and stability of the transimpedance amplifier 102 are achieved.

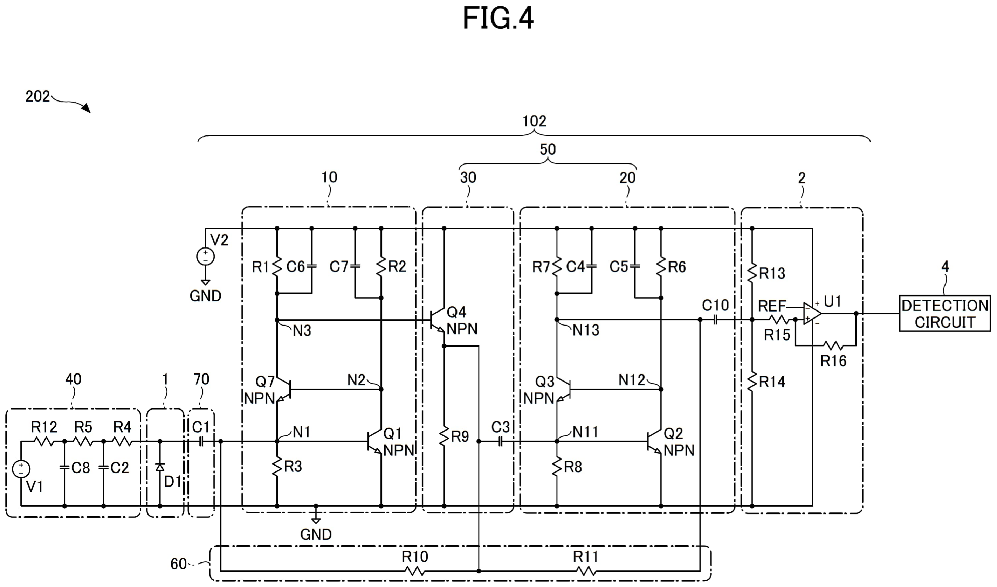

FIG. 4 is a circuit diagram showing a specific example of the measuring instrument including the transimpedance amplifier according to the second embodiment. A transimpedance amplifier 102 shown in FIG. 4 differs from the transimpedance amplifier circuit 101 shown in FIG. 2 in that the transimpedance amplifier 102 includes a feedback circuit 60.

In FIG. 4, the feedback circuit 60 feeds back the output of the I/V transimpedance amplifier 20 to a node N1 that serves as the input of the I/V transimpedance amplifier 10, through resistors R10 and R11. The feedback circuit 60 also feeds back the output of the I/V transimpedance amplifier 20 to the input to the I/V transimpedance amplifier 20, through the resistor R11. A series circuit of the resistors R10 and R11 is connected between nodes N13 and N1. An intermediate node between the resistors R10 and R11 is connected between the output of the V/I conversion circuit 30 (an emitter of a transistor Q4) and the input of the I/V transimpedance amplifier 20 (a node N11). More specifically, the intermediate node is connected between the emitter of the transistor Q4 and a capacitor C3.

The present invention is not limited to the above embodiments. The above embodiments can be implemented in various other forms, and various combinations, omissions, substitutions, and changes can be made without departing from the gist of the invention. These embodiments and variations thereof are included in the scope and gist of the invention, as well as in the scope of the invention described in the claims.

For example, a sensor that outputs current or charge to the input of the transimpedance amplifier 10 through AC coupling is not limited to the radiation sensor 1. However, other sensors such as optical sensors that detect light may be adopted.

A transistor is not limited to a bipolar transistor, and may be a MOS transistor. In this case, it is sufficient to replace a base with a gate, a collector with a drain, and an emitter with a source.

## Claims

1. A transimpedance amplifier circuit (101, 102) comprising:
a first transimpedance amplifier (10) that converts current to voltage; and
one or more circuit blocks (50) connected to an output side of the first transimpedance amplifier (10),
wherein each of the circuit blocks (50) includes:
a conversion circuit (30) that converts the voltage to current, and
a second transimpedance amplifier (20) connected to an output side of the conversion circuit (30) that converts the current to voltage.

2. The transimpedance amplifier circuit according to claim 1, wherein at least one output among the circuit blocks (50) is fed back.

3. The transimpedance amplifier circuit according to claim 2, wherein the at least one output among the circuit blocks (50) is fed back to an input side of the first transimpedance amplifier (10).

4. The transimpedance amplifier circuit according to claim 2, wherein an output of each second transimpedance amplifier (20) is fed back to a portion or all of:
an input to the second transimpedance amplifier (20); and
inputs to one or more second transimpedance amplifiers (20) preceding the second transimpedance amplifier (20).

5. The transimpedance amplifier circuit according to any one of claims 1 to 4, wherein the conversion circuit (30) is an emitter follower or a source follower, and
wherein the second transimpedance amplifier (20) is a regulated cascode circuit (RGC) transimpedance amplifier.

6. The transimpedance amplifier circuit according to any one of claims 1 to 4, wherein the conversion circuit (30) converts the voltage to the current through a current mirror circuit.

7. The transimpedance amplifier circuit according to claim 6, wherein the current mirror circuit is a multi-current mirror circuit.

8. A measuring instrument (201, 202) comprising the transimpedance amplifier circuit according to any one of claims 1 to 7.

9. The measuring instrument according to claim 8, further comprising:
a sensor (1) that outputs the current or charge to an input of the first transimpedance amplifier (10) through AC coupling;
a comparator (2) to which an output of the second transimpedance amplifier (20) included in a last circuit block of the circuit blocks (50) is supplied; and
a counter (3) that counts an output of the comparator (2).
